# FASCICULE DE BREVET EUROPEEN

(11) **EP 4 577 006 B1**
(45) Date de publication et mention de la délivrance du brevet: **29.04.2026**
(21) Numéro de dépôt: 24219549.3
(22) Date de dépôt: 12.12.2024
(51) Int. Cl.: H10H 29/01, H10H 29/856, H10H 29/851, H10H 29/80

(54) **DISPOSITIF OPTOÉLECTRONIQUE ET PROCÉDÉ DE FABRICATION ASSOCIÉ**
OPTOELEKTRONISCHE VORRICHTUNG UND VERFAHREN ZU IHRER HERSTELLUNG
OPTOELECTRONIC DEVICE AND METHOD FOR MANUFACTURING SAME

(30) Priorité: 18.12.2023 FR 2314363
(43) Date de publication de la demande: 25.06.2025
(73) Titulaire: Commissariat à l'Energie Atomique et aux Energies Alternatives, 75015 Paris (FR)
(72) Inventeur: PERNEL, Carole, 38054 Grenoble Cedex 09 (FR); ALTAZIN, Stéphane, 38054 Grenoble Cedex 09 (FR); QUESNEL, Etienne, 38054 Grenoble Cedex 09 (FR)
(74) Mandataire: Hautier IP

(56) Documents cités:
- CN-A- 116 469 987
- FR-A1- 3 061 358
- US-A1- 2023 155 075

## Description

### DOMAINE TECHNIQUE

La présente invention concerne un dispositif optoélectronique notamment destiné à équiper un écran d'affichage ou un système de projection d'images. La présente invention concerne également un procédé de fabrication d'un tel dispositif optoélectronique.

### ETAT DE LA TECHNIQUE

Il existe des dispositifs optoélectroniques comportant une matrice de diodes électroluminescentes présentant une surface d'émission revêtue au moins en partie par des convertisseurs de couleur de lumière. De tels dispositifs optoélectroniques peuvent former des écrans d'affichage ou des systèmes de projection d'images comportant une matrice de pixels lumineux de différentes couleurs.

Les diodes électroluminescentes peuvent être formées à base d'un matériau semiconducteur comprenant des éléments de la colonne III et de la colonne V du tableau périodique, tel qu'un composé III-V, notamment le nitrure de gallium (GaN), le nitrure d'indium et de gallium (InGaN) ou le nitrure d'aluminium et de gallium (AlGaN). Elles sont agencées de manière à former une matrice de diodes électroluminescentes présentant une surface d'émission au travers de laquelle est transmis le rayonnement lumineux émis par les diodes électroluminescentes.

Dans le cas d'un écran d'affichage ou d'un système de projection d'images, le dispositif optoélectronique peut ainsi comporter une matrice de pixels lumineux, chaque pixel lumineux comportant une ou plusieurs diodes électroluminescentes. Dans le but d'obtenir des pixels lumineux émettant des lumières de différentes couleurs, par exemple bleues, vertes ou rouges, les diodes électroluminescentes peuvent être adaptées à émettre une lumière bleue, et certains pixels lumineux peuvent être associés à des convertisseurs de couleur de lumière, tels que des plots photoluminescents, adaptés à absorber la lumière bleue émise par les diodes électroluminescentes, et à émettre, en réponse, une lumière verte ou rouge. Les plots photoluminescents sont habituellement formés d'une matrice liante, appelée plus bas résine, comportant des particules d'un matériau photoluminescent tel que le grenat d'yttrium et d'aluminium (YAG, pour Yttrium Aluminium Garnet, en anglais) activé par l'ion cérium YAG:Ce.

L'émission des diodes électroluminescentes, et donc des pixels, est plus ou moins directive angulairement et des phénomènes de diaphonie optique (ou « optical crosstalk » en anglais) peuvent être générés entre pixels ou entre diodes électroluminescentes. En outre, l'utilisation de convertisseurs de couleur de lumière, tels que les plots photoluminescents ci-dessus introduits, peuvent accentuer ces phénomènes de diaphonie optique.

Pour limiter ces phénomènes, il a été proposé d'isoler optiquement les pixels entre eux, soit par l'ajout d'une matrice absorbante (ou « black matrix » en anglais) entre les pixels, soit, plus avantageusement, par l'ajout de miroirs latéraux, de préférence en aluminium ou en argent, sur des flancs des plots photoluminescents. Des procédés de fabrication desdits miroirs latéraux sont décrits dans les documents de brevet référencés FR3101130 A1, FR3061358 A1, FR3083370 A1, FR3087580 A1 et US2023/0033031 A1. Plus particulièrement, il est proposé, à travers ces références, différentes techniques de fabrication de cavités au-dessus de pixels bleus pour pourvoir les remplir d'une résine chargée en boîtes (ou points) quantiques (ou « quantum dots » ou encore QDs en anglais) pour la conversion de la lumière bleue émise par les pixels en une lumière verte ou en une lumière rouge. Cependant, ces techniques requièrent de nombreuses étapes technologiques (dépôt de SiO2, lithogravure, dépôt métallique par dépôt de couches atomiques (ou « atomic layer deposition » ou ALD en anglais), gravure, démontage, report aligné, etc.), rendant leur intégration complexe. Il est encore connu de l'article de Siontas et al. intitulé « Broadband visible-to-telecom wavelength germanium quantum dot photodetectors » et paru dans APPLIED PHYSICS LETTERS 113, 251901 (2018) un remplissage des cavités à l'aide de QDs en suspension dans un solvant qui s'évapore dans un second temps (séchage) laissant uniquement les QDs. Il y est plus particulièrement divulgué de déposer, dans les cavités d'une matrice d'alumine nanoporeuse, des QDs de pérovskite à base de CsPbBr3 dilués dans du diméthylsulfoxyde (ou DMSO) en tant que solvant, et de les chauffer dans un deuxième temps pour évaporer le diméthylsulfoxyde.

Par ailleurs, il est connu, du document de brevet référencé EP2708492 B1, une couche mésoporeuse comprenant des agrégats de couplage d'absorbeurs et de convertisseurs de lumière (ou « J-aggregates » en anglais) et des boîtes (ou points) quantiques permettant d'augmenter le transfert d'énergie entre particules fluorescentes (ou « Forster resonance energy transfer » ou FRET en anglais) et donc le taux d'émission d'un assemblage comprenant une telle couche mésoporeuse.

CN 116 469 987 A décrit un dispositif optoélectronique comprenant un empilement d'une couche comprenant une pluralité de diodes électroluminescentes et d'une couche de confinement de lumière comprenant des parois réfléchissantes et l'alumine poreuse. US 2023/155075 A1 décrit un dispositif optoélectronique comprenant une pluralité de diodes électroluminescentes disposées dans des cavités formées dans de l'alumine poreuse, ainsi qu'une couche de confinement de lumière composée de matériaux de conversion de lumière et des parois réfléchissantes.

Un objectif de la présente invention est de proposer un dispositif optoélectronique, notamment destiné à équiper un écran d'affichage ou un système de projection d'images amélioré, relativement aux dispositifs optoélectroniques existants, notamment en réduisant les phénomènes de diaphonie optique.

Un objectif de la présente invention est de proposer un tel dispositif présentant un meilleur taux de conversion de lumière. En alternative ou en complément, un objectif de la présente invention est de proposer un tel dispositif dont le procédé de fabrication est plus simple, ou à tout le moins pas plus complexe, que les procédés existants.

Un autre objectif de la présente invention est de proposer un dispositif optoélectronique et un procédé de fabrication associé qui soient d'une intégration technologique plus immédiate que les solutions de l'art antérieur.

### RESUME

Pour atteindre cet objectif, selon un premier aspect de l'invention, on prévoit un dispositif optoélectronique comprenant :
a. un empilement comprenant :
   i. une pluralité de diodes électroluminescentes à jonction P-N disposées à distance les unes des autres, et
   ii. une pluralité de plots électriquement conducteurs disposés entre les diodes électroluminescentes,
      les plots électriquement conducteurs étant isolés électriquement d'au moins une zone p ou n des jonctions P-N des diodes électroluminescentes,
b. une couche de confinement de lumière s'étendant sur l'empilement et comprenant des parois réfléchissantes définissant ou délimitant entre elles des espaces ou volumes situés chacun au droit d'au moins une, de préférence de chaque, diode électroluminescente.

Le dispositif optoélectronique est tel que la couche de confinement de lumière comprend en outre de l'alumine poreuse dans au moins certains desdits espaces, l'alumine poreuse présentant, dans au moins un espace, de préférence au moins deux espaces, voire dans chaque espace, parmi lesdits au moins certains desdits espaces, au moins deux pores ouverts sur une première face de la couche de confinement qui est située à l'opposé de l'empilement, le dispositif optoélectronique étant caractérisé au moins en ce que l'une au moins, potentiellement chaque, paroi réfléchissante est à base d'alumine poreuse et d'un matériau réfléchissant situé dans les pores de l'alumine poreuse.

Afin de profiter des propriétés de diffusion optique de l'alumine (nano)poreuse, les pores de l'alumine poreuse présentent de préférence des dimensions transversales comprises entre 1 et 500 nm et de préférence entre 50 et 400 nm. Toujours afin de profiter des propriétés de diffusion optique de l'alumine nanoporeuse, en alternative ou en complément à la préférence précédente, les pores de l'alumine poreuse présentent de préférence une périodicité comprise entre 200 et 700 nm. Ainsi, il est avantageusement prévu d'avoir plusieurs pores au-dessus d'au moins une, de préférence au-dessus de chaque, diode électroluminescente, et donc a fortiori par pixel, afin de maximiser les propriétés optiques du dispositif optoélectronique. Aussi, la taille des pores est de préférence supérieure à la dimension des particules de conversion de couleur que l'on souhaite glisser à l'intérieur, de sorte à pouvoir avoir au moins une particule de conversion de couleur dans chaque pore.

Selon un exemple du premier aspect de l'invention, l'alumine poreuse présente, dans au moins un espace, de préférence au moins deux espaces, voire dans chaque espace, parmi lesdits au moins certains desdits espaces, au moins huit pores ouverts sur la première face de la couche de confinement qui est située à l'opposé de l'empilement. L'on obtient ainsi une meilleure extraction de la lumière émise par la ou les diodes électroluminescentes sous-jacentes.

Selon un exemple du premier aspect de l'invention, alternatif au précédent, l'alumine poreuse présente, dans au moins un espace, de préférence au moins deux espaces, voire dans chaque espace, parmi lesdits au moins certains desdits espaces, au moins un pore tous les 2×λ, où λ représente la longueur d'onde à extraire et au moins quatre pores par espace (cas pixel de 1µm).

Selon un exemple du premier aspect de l'invention, au moins un, de préférence chaque, pore ouvert sur la première face de la couche de confinement qui est située à l'opposé de l'empilement présente un taux de remplissage, en le matériau de conversion de couleur de lumière, sensiblement égale à 30%. L'on optimise ainsi le taux de conversion de couleur. Plus particulièrement, par rapport à l'état de l'art qui consiste en un pore d'Al2O3 au-dessus d'une LED, le taux de conversion obtenu ici est bien meilleur.

Selon un deuxième aspect de l'invention, on prévoit un procédé de fabrication d'un dispositif optoélectronique, le procédé comprenant les étapes suivantes :
a. fournir un empilement comprenant :
   i. une pluralité de diodes électroluminescentes à jonction P-N disposées à distance les unes des autres, et
   ii. une pluralité de plots électriquement conducteurs disposés entre les diodes électroluminescentes,
      les plots électriquement conducteurs étant isolés électriquement d'au moins une zone p ou n des jonctions P-N des diodes électroluminescentes,
b. former, sur l'empilement, une couche de confinement de lumière comprenant des parois réfléchissantes définissant ou délimitant entre elles des espaces ou volumes situés chacun au droit d'au moins une, de préférence de chaque, diode électroluminescente, par :
   i. dépôt d'une couche à base d'aluminium sur une face principale de l'empilement par laquelle les diodes électroluminescentes sont configurées pour émettre, puis
   ii. anodisation de la couche à base d'aluminium au moins en dehors de zones situées au droit des plots conducteurs de l'empilement.

Le procédé est tel que l'anodisation est paramétrée de sorte que de l'alumine poreuse soit formée dans au moins certains desdits espaces, en présentant, dans au moins un espace, de préférence au moins deux espaces, voire dans chaque espace, parmi lesdits au moins certains desdits espaces, au moins deux pores ouverts sur une première face de la couche de confinement qui est située à l'opposé de l'empilement. Le procédé est caractérisé en ce que l'étape d'anodisation comprend l'anodisation d'une partie de la couche à base d'aluminium qui est située au droit d'au moins un plot électriquement conducteur et comprenant en outre le dépôt d'un matériau réfléchissant dans les pores de l'alumine poreuse située au droit dudit au moins un plot électriquement conducteur.

Selon un troisième aspect de l'invention, on prévoit un écran d'affichage ou système de projection d'au moins une image comprenant au moins un dispositif optoélectronique tel qu'introduit ci-dessus.

Il est ainsi avantageusement permis de profiter de la nature préférentiellement anisotrope de l'anodisation de l'aluminium. En effet, le dispositif optoélectronique peut comprendre un espace rempli d'alumine poreuse au-dessus de chaque diode électroluminescente, et l'alumine poreuse comportant des pores présentant un fort facteur de forme, le confinement de la lumière par la couche de confinement s'en trouve amélioré, notamment par augmentation de la diffusion dans chaque pore de la lumière émise par la diode électroluminescente sous-jacente, et en réduisant par là-même les phénomènes de diaphonie optique, au-delà de ce que permettent les seules parois réfléchissantes, surtout lorsque les pores de l'alumine poreuse sont remplis d'un matériau de conversion de couleur de lumière.

Il apparaîtra par la suite que le dispositif optoélectronique tel qu'introduit ci-dessus peut être un produit intermédiaire destiné à la fabrication d'un dispositif optoélectronique plus avancé. Dans ce cadre, notons que l'alumine poreuse remplissant l'espace au-dessus de chaque diode électroluminescente présente à tout le moins l'avantage de permettre aisément une gravure profonde et anisotrope de cet espace

En considérant le dispositif optoélectronique tel qu'introduit ci-dessus comme un produit intermédiaire, il est encore avantageusement permis, grâce à ce produit intermédiaire, de fabriquer des dispositifs optoélectroniques encore améliorés, ou de façon plus aisé, relativement à l'existant.

### BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
La figure 1 représente une vue en coupe d'une partie d'un dispositif optoélectronique selon un premier mode de réalisation ne faisant pas partie de l'invention ou un produit intermédiaire permettant d'obtenir un dispositif optoélectronique selon le deuxième mode de réalisation représenté sur la figure 2.
La figure 2 représente une vue en coupe d'une partie d'un dispositif optoélectronique selon un deuxième mode de réalisation ne faisant pas partie de l'invention.
La figure 3 représente une vue en coupe d'une partie d'un dispositif optoélectronique selon un troisième mode de réalisation ne faisant pas partie de l'invention ou un produit intermédiaire permettant d'obtenir un dispositif optoélectronique selon le quatrième mode de réalisation représenté sur la figure 4.
La figure 4 représente une vue en coupe d'une partie d'un dispositif optoélectronique selon un quatrième mode de réalisation ne faisant pas partie de l'invention.
La figure 5 représente une vue en coupe d'une partie d'un dispositif optoélectronique selon une variante du premier mode de réalisation qui est illustré sur la figure 1.
La figure 6 représente une vue en coupe d'une partie d'un dispositif optoélectronique selon une variante du deuxième mode de réalisation qui est illustré sur la figure 2.
La figure 7 représente une vue en coupe d'une partie d'un dispositif optoélectronique selon une variante du troisième mode de réalisation qui est illustré sur la figure 3 ou un produit intermédiaire permettant d'obtenir un dispositif optoélectronique selon une variante du quatrième mode de réalisation qui est illustrée sur la figure 8.
La figure 8 représente une vue en coupe d'une partie d'un dispositif optoélectronique selon une variante du troisième mode de réalisation ne faisant pas partie de l'invention qui est illustré sur la figure 3.
Les figures 9 à 12 illustrent schématiquement des étapes d'un mode de mise en oeuvre d'un procédé de fabrication d'un dispositif optoélectronique tel qu'illustré sur la figure 1.
Les figures 13 à 15 illustrent schématiquement des étapes d'un mode de mise en oeuvre d'un procédé de fabrication d'un dispositif optoélectronique tel qu'illustré sur la figure 5.
La figure 16 représente une vue en coupe d'une partie d'un dispositif optoélectronique selon un cinquième mode de réalisation de l'invention.
La figure 17 représente une vue en coupe d'une partie d'un dispositif optoélectronique (le cas échéant sans l'élément référencé 2200) selon une première variante du cinquième mode de réalisation de l'invention qui est illustré sur la figure 16. La figure 17 peut en alternative être vue comme une étape d'un procédé de fabrication du dispositif optoélectronique tel qu'illustré sur la figure 18 à partir de celui illustré sur la figure 16.
La figure 18 représente une vue en coupe d'une partie d'un dispositif optoélectronique selon une variante du cinquième mode de réalisation de l'invention qui est illustré sur la figure 16.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les épaisseurs et autres dimensions des différentes couches et autres éléments illustrés ne sont pas nécessairement représentatives de la réalité, et ne sont pas nécessairement à l'échelle.

### DESCRIPTION DÉTAILLÉE

Avant d'entamer une revue détaillée de modes de réalisation faisant partie de l'invention ou non, sont énoncées ci-après des caractéristiques optionnelles du premier aspect de l'invention qui peuvent éventuellement être utilisées en association ou alternativement :
Selon un exemple, chacun des espaces est rempli de l'alumine poreuse.

Selon un exemple, les pores de l'alumine poreuse forment des canaux débouchant sur la première face de la couche de confinement. Les pores de l'alumine poreuse présentent ainsi un facteur de forme significativement fort, de sorte à augmenter encore la diffusion dans chaque pore de la lumière émise par la diode électroluminescente sous-jacente.

Selon un exemple, les pores de l'alumine poreuse forment des canaux s'étendant principalement selon une direction perpendiculaire à la première surface de la couche de confinement. Les dimensions longitudinales des pores sont de préférence supérieures à leurs dimensions transversales.

Selon un exemple, au moins certains des pores, de préférence tous les pores, présentent une dimension Lp en longueur, prise en projection selon une direction perpendiculaire à la première face, strictement inférieure à une épaisseur E12 de la couche de confinement, et de préférence inférieure de 2 nm ; il reste donc quelques nm d'alumine ou d'aluminium au fond des pores. La couche de confinement peut présenter une épaisseur E12 comprise entre 500 nm et 10 µm ou plus.

Selon un exemple, les pores s'étendent sensiblement jusqu'à l'empilement, potentiellement sans l'atteindre, mais de préférence en l'atteignant pour ne pas perdre en efficacité optique. Le risque de délamination de la couche de confinement depuis l'empilement est limité mécaniquement du fait que la stabilité de la structure peut être assuré par les piliers en AI non porosifiés au-dessus des contacts, tout en profitant d'un facteur de forme encore plus fort des pores de l'alumine poreuse.

Selon un exemple, au moins un pore, de préférence chaque pore, présente un facteur de forme défini par des dimensions transversales sensiblement comprises entre 40 nm et 800 nm, et/ou une dimension longitudinale sensiblement comprise entre 500 nm et 10 µm ou plus, et de préférence une dimension longitudinale sensiblement comprise entre 1 µm et 5 µm.

En complément ou en alternative, les pores ouverts sur la première face de la couche de confinement peuvent occuper une surface sensiblement égale à 30% de la surface totale de cette couche de confinement et/ou les pores ouverts au-dessus d'au moins une diode électroluminescente qui sont adjacents entre eux peuvent être distants deux à deux, par leurs centres, d'une distance sensiblement égale à une longueur d'onde de la lumière émise par la diode électroluminescente sous-jacente, cette longueur d'onde appartenant typiquement au spectre de lumière bleue, soit par exemple entre 380 et 450 nm.

L'on profite ainsi de ce que l'anodisation de l'aluminium peut être paramétrée de façon connue et maîtrisée pour s'assurer que les pores formés présentent des dimensions propres à permettre leur remplissage, notamment par différents matériaux de conversion de couleur de lumière.

Selon un exemple, l'empilement comprend en outre :
a. un substrat porteur,
b. une matrice de structures émissives s'étendant sur le substrat porteur, la matrice de structures émissives comprenant la pluralité de diodes électroluminescentes qui s'étendent sur le substrat porteur par l'intermédiaire d'une couche d'interfaçage (ou de collage) et la pluralité de plots électriquement conducteurs s'étendant soit directement sur le substrat porteur, soit par l'intermédiaire d'une paroi d'isolation électrique. Au moins une, de préférence chaque, structure émissive comprend au moins une diode électroluminescente et au moins une partie de chacun des plots électriquement conducteurs adjacents, une paroi d'isolation électrique séparant le cas échéant au moins en partie la diode électroluminescente et chacun des plots électriquement conducteurs adjacents pour éviter de mettre en court-circuit au moins une zone p ou n des jonctions P-N des diodes électroluminescentes.

Selon un exemple, au moins une, de préférence chaque, structure émissive comprend en outre au moins une paroi d'isolation électrique ou paroi diélectrique, le cas échéant partielle :
a. entre au moins un plot électriquement conducteur et au moins une diode électroluminescente adjacente, et/ou
b. entre au moins un plot électriquement conducteur et le substrat porteur.

Selon un exemple, au moins une, de préférence chaque, structure émissive comprend en outre des parois diélectriques dont des premières parois diélectriques s'étendant entre au moins un, de préférence chaque, plot conducteur et la couche d'interfaçage et des secondes parois diélectriques s'étendant sur au moins une partie des côtés latéraux de chaque plot conducteur, les première et secondes parois diélectriques étant de préférence jointes entre elles, de sorte que chaque plot conducteur soit isolé électriquement sur une partie de son pourtour.

Selon un exemple, le substrat porteur comprend au moins un circuit-intégré propre à une application (ou ASIC acronyme de l'anglais « application-specific integrated circuit ») et au moins un plot de connexion électrique entre ledit circuit-intégré et au moins une, par exemple plusieurs, des diodes électroluminescentes. En complément ou en alternative, l'empilement comprend en outre une couche d'électrode à base d'un matériau conducteur et transparent, tel que l'oxyde d'indium-étain ou (ITO pour l'anglais « indium tin oxide »), la couche d'électrode s'étendant, le cas échéant continûment, entre d'une part les pluralités de diodes électroluminescentes et de plots électriquement conducteurs et d'autre part la couche de confinement de lumière.

Selon un exemple, l'une au moins, potentiellement chaque, paroi réfléchissante est à base d'aluminium.

Selon un exemple, au moins une partie d'un pourtour extérieur, notamment latéral, de l'une au moins, de préférence de chaque, paroi réfléchissante est à base ou est constituée d'aluminium.

Selon un exemple, au moins un plot électriquement conducteur est à base d'aluminium, le cas échéant ledit au moins un plot électriquement conducteur et la paroi réfléchissante située au droit dudit au moins un plot électriquement conducteur forment un volume de matière homogène (ou « bulk » en anglais). Les plots électriquement conducteurs peuvent ainsi être avantageusement réalisés dans un même matériau que celui à base duquel les parois réfléchissantes sont constituées, ce qui simplifie le dispositif et son procédé de fabrication, notamment en évitant une étape technologique de dépôt, par exemple par électrodépôt (ou « electrodeposition » en anglais), de plots électriquement conducteurs à base d'un autre matériau métallique que l'aluminium, par exemple à base de cuivre.

Selon un exemple, le dispositif optoélectronique comprend en outre un matériau de conversion de couleur de lumière situé dans les pores de l'alumine poreuse située au droit d'au moins une diode électroluminescente, de préférence au droit de chaque diode électroluminescente. Les phénomènes de diaphonie optique s'en trouvent encore avantageusement réduits. Selon cet exemple, le matériau de conversion de couleur de lumière est greffé aux parois internes de pores. Ainsi, les interactions surface/particules de conversion sont fortes et le remplissage des pores avec les particules est amélioré. En outre, le greffage des particules de conversion sur les parois internes des pores permet aux particules de conversion de mieux résister au flux, ce qui assure potentiellement une meilleure résistance au vieillissement du dispositif optoélectronique.

Selon un exemple, le matériau de conversion de couleur de lumière est situé dans, et le cas échéant rempli, au moins un, par exemple au moins certains, de préférence chacun, des pores (ou canaux) formés par l'alumine poreuse.

Selon un exemple, la couche de confinement de lumière est exempte d'alumine poreuse dans au moins un, potentiellement dans plusieurs, desdits espaces.

Selon l'exemple précédent, au moins un, de préférence chaque, espace exempt d'alumine poreuse est rempli d'un matériau de conversion de couleur de lumière. Il est ainsi possible de concevoir un dispositif optoélectronique présentant différentes configurations de sa couche de confinement selon la diode électroluminescente considérée ou le groupe de diodes électroluminescentes considéré, ledit groupe pouvant notamment constituer un pixel. Le dispositif optoélectronique proposé présente donc avantageusement une modularité à cet égard.

Selon un exemple, le matériau de conversion de couleur de lumière comprend au moins les un(e)s parmi :
a. des boîtes quantiques,
b. des agrégats de couplage d'absorbeurs et de convertisseurs de lumière (ou « J-aggregates » en anglais),
c. des nanoparticules phosphorescentes (ou fluorescentes), et
d. des pérovskites,
le cas échéant mis(es) en solution dans un solvant ou incorporé(es) dans une résine. Avantageusement, les différents matériaux de conversion de couleur de lumière usuellement utilisés dans le domaine des écrans d'affichage et autres systèmes de projection d'images sont insérables dans les pores de l'alumine poreuse, et donc sont utilisables dans le cadre de la présente invention.

Selon un exemple, le matériau de conversion de couleur de lumière remplissant au moins un, de préférence chaque, espace exempt d'alumine poreuse comprend au moins l'un choisi parmi :
a. des boîtes quantiques, et
b. des agrégats de couplage d'absorbeurs et de convertisseurs de lumière (ou « J-aggregates » en anglais).

Selon un exemple, les diodes électroluminescentes sont configurées pour émettre une lumière d'une première longueur d'onde déterminée, par exemple la couleur bleue, selon une direction sensiblement perpendiculaire à la première face de la couche de confinement.

En complément ou en alternative, le matériau de conversion de couleur de lumière est propre à convertir la lumière émise à la première longueur d'onde en une lumière présentant une deuxième longueur d'onde différente de la première, par exemple la première longueur d'onde étant situé dans le bleu et la deuxième longueur d'onde étant située dans l'un parmi le vert et le rouge.

Il est entendu que les caractéristiques optionnelles ci-dessus énoncées peuvent chacune qualifier, en alternative au premier aspect de l'invention tel qu'introduit plus haut, un dispositif optoélectronique comprenant :
a. un empilement comprenant :
   i. une pluralité de diodes électroluminescentes disposées à distance les unes des autres, et
   ii. une pluralité de plots électriquement conducteurs disposés entre les diodes électroluminescentes,
b. une couche de confinement de lumière s'étendant sur l'empilement et comprenant des parois réfléchissantes définissant ou délimitant entre elles des espaces ou volumes situés chacun au droit d'une diode électroluminescente.

Sont énoncées ci-après des caractéristiques optionnelles du deuxième aspect de l'invention qui peuvent éventuellement être utilisées en association ou alternativement :
Selon un exemple, la couche à base d'aluminium est déposée de sorte à présenter une épaisseur sensiblement comprise entre 500 nm et 10 µm, de préférence sensiblement comprise entre 1 et 6 µm.

Selon un exemple, l'étape d'anodisation de la couche à base d'aluminium est paramétrée de sorte que l'alumine poreuse forme des canaux débouchant par les pores ouverts sur la première face de la couche de confinement, et de préférence de sorte qu'au moins un canal, par exemple chaque canal, présente des dimensions transversales sensiblement comprises entre 40 nm et 800 nm, et/ou une dimension longitudinale sensiblement comprise entre 500 nm et 10 µm, de préférence sensiblement comprise entre 1 et 6µm.

Selon un exemple, l'étape d'anodisation de la couche à base d'aluminium est paramétrée de sorte qu'au moins certains des pores (ou canaux) présentent une dimension Lp en longueur, prise en projection selon une direction perpendiculaire à la première face, strictement supérieure à une moitié d'une épaisseur E12 de la couche de confinement.

Selon un exemple, l'étape d'anodisation de la couche à base d'aluminium est paramétrée de sorte qu'au moins certains des pores (ou canaux) présentent une dimension Lp en longueur, prise en projection selon une direction perpendiculaire à la première face, au plus égale, et de préférence strictement inférieure, par exemple de 2 nm, à une épaisseur de la couche à base d'aluminium. On limite ainsi le risque de délamination de la couche de confinement depuis l'empilement.

Selon un exemple, le procédé comprend en outre, suite au dépôt de la couche à base d'aluminium et avant son anodisation :
a. déposer un masque sur des zones de la couche à base d'aluminium qui sont situées sensiblement au droit des plots conducteurs de l'empilement, le masque présentant des ouvertures situées au droit des diodes électroluminescentes,
l'anodisation de la couche à base d'aluminium étant réalisée à travers les ouvertures du masque déposé. Le masque peut être à base d'oxyde de silicium ou de nitrure de silicium (SiN).

Selon un exemple, l'étape consistant à fournir l'empilement comprend le dépôt, entre les diodes électroluminescentes, d'aluminium pour former au moins une partie de la pluralité de plots électriquement conducteurs de l'empilement et cette étape de dépôt est prolongée pour réaliser le dépôt de la couche à base d'aluminium. De la sorte, la formation des plots électriquement conducteurs et la formation de la couche d'aluminium peuvent être implémentées dans une même étape technologique de dépôt d'aluminium.

Selon un exemple, le procédé de fabrication comprend en outre le dépôt d'un matériau de conversion de couleur de lumière dans les pores de l'alumine poreuse, au niveau d'au moins un, de préférence de certains, par exemple de chacun, desdits espaces. Selon cet exemple, le matériau de conversion et/ou les parois internes des pores sont fonctionnalisés, avant le dépôt du matériau de conversion de couleur de lumière dans les pores de l'alumine poreuse, de sorte à obtenir un greffage des unes ou autres, par exemple par des liaisons -OH de surface, créées le cas échéant par un traitement avec une chimie alcaline ou par un traitement par plasma sec ou par adsorption d'un ligand.

Selon un exemple, alternatif au précédent le procédé de fabrication comprend le retrait, par exemple par gravure, de l'alumine poreuse au niveau d'au moins un, par exemple de certains, desdits espaces, et le remplissage d'au moins un des espaces ainsi évidés par un matériau de conversion de couleur de lumière. L'on profite ainsi tout à la fois de la possibilité connue de graver sélectivement l'alumine poreuse relativement à l'aluminium et de la nature anisotrope de l'anodisation de l'aluminium, pour obtenir des parois réfléchissantes bien planes et sensiblement perpendiculaires relativement à la face de l'empilement par laquelle les diodes électroluminescentes sont configurées pour émettre.

On entend par une couche, une paroi, un plot ou un élément à base d'un matériau A, une couche, une paroi, un plot ou un élément comprenant ce matériau A et éventuellement d'autres matériaux, respectivement.

On entend par un paramètre « sensiblement égal/supérieur/inférieur à » une valeur donnée que ce paramètre est égal/supérieur/inférieur à la valeur donnée, à plus ou moins 20 %, voire 10 %, près de cette valeur. On entend par un paramètre « sensiblement compris entre » deux valeurs données que ce paramètre est au minimum égal à la plus petite valeur donnée, à plus ou moins 20 %, voire 10 %, près de cette valeur, et au maximum égal à la plus grande valeur donnée, à plus ou moins 20 %, voire 10 %, près de cette valeur.

Il est précisé que, dans le cadre de la présente invention, les termes « sur », « surmonte », « surplombe », « recouvre », « sous-jacent » et leurs équivalents ne signifient pas forcément « au contact de ». Ainsi par exemple, le report, l'application ou le dépôt d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

Un élément est dit « microscopique » lorsqu'il présente des dimensions égales ou inférieures à quelques micromètres. Ainsi une microLED par exemple présente des dimensions égales ou inférieures à quelques micromètres.

Dans la description qui suit, les épaisseurs de substrat, de film ou de couche sont généralement mesurées selon des directions perpendiculaires au plan d'extension principale du substrat, du film ou de la couche.

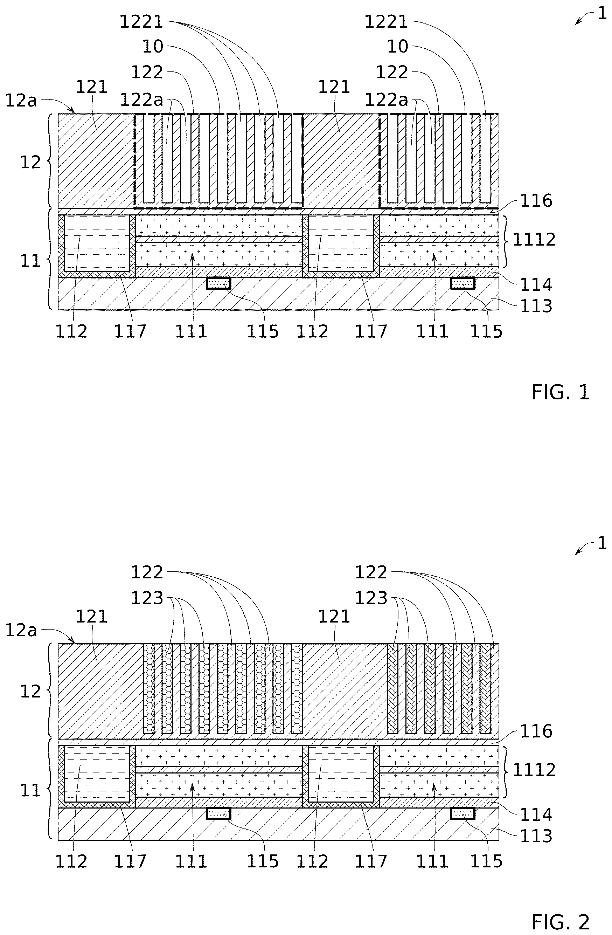

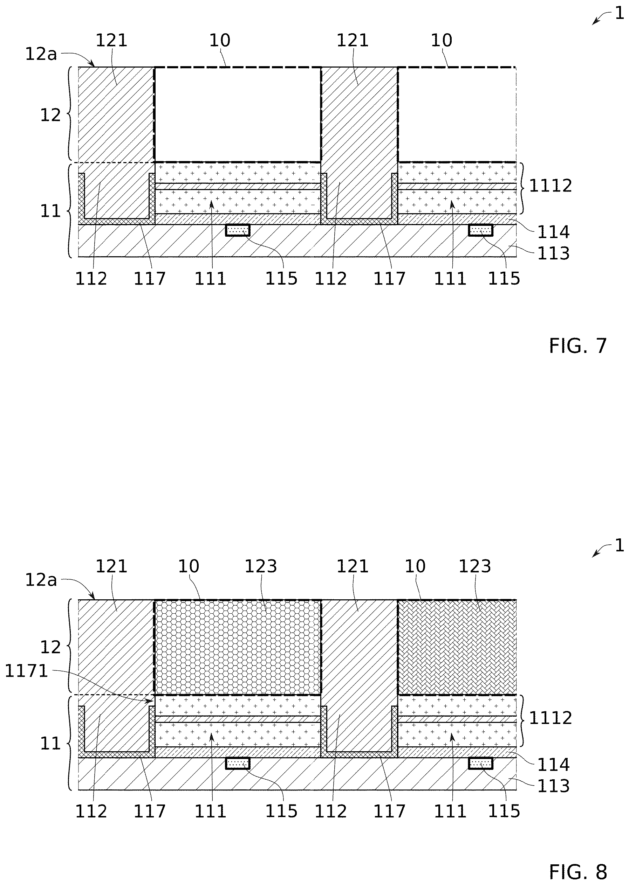

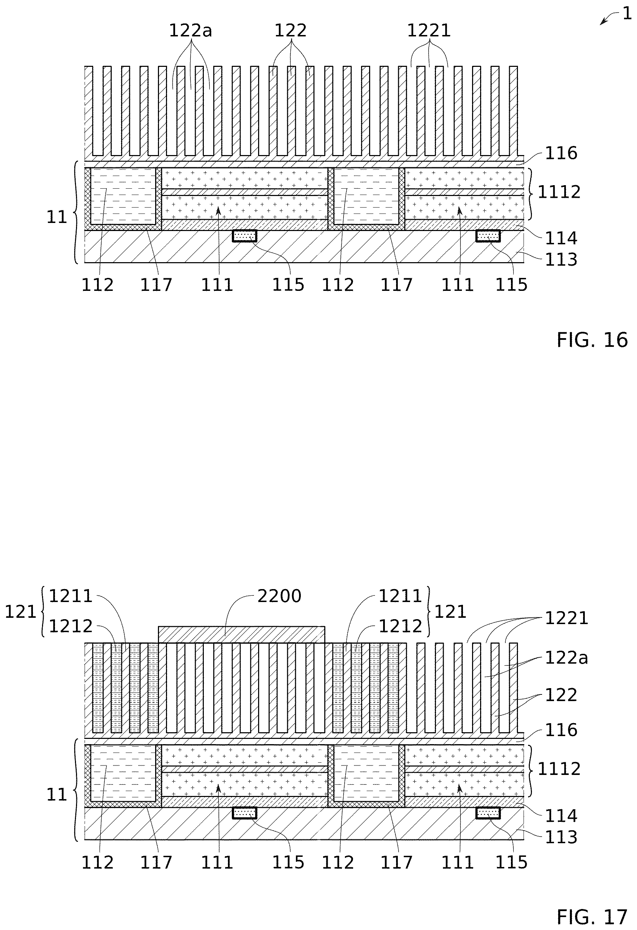

En référence aux figures 1 à 8 et 16 à 18, le premier aspect de l'invention concerne un dispositif optoélectronique 1.

Comme l'illustrent ces figures, le dispositif optoélectronique 1 selon le premier aspect de l'invention comprend un empilement 11 et une couche de confinement de lumière 12. Plus particulièrement, chacune de ces figures illustre une vue en coupe d'une partie d'un dispositif optoélectronique 1 selon un mode de réalisation du premier aspect de l'invention.

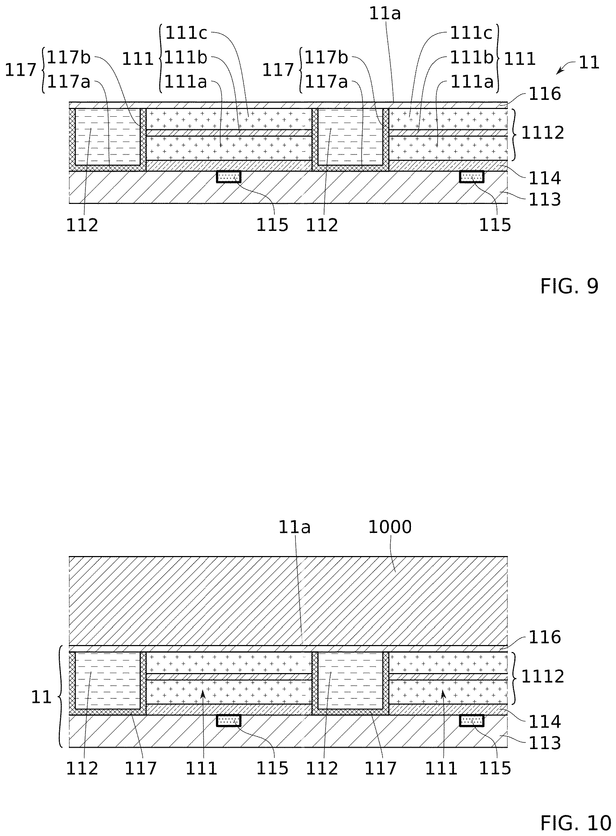

L'invention concerne également, selon un deuxième aspect, un procédé de fabrication d'un dispositif optoélectronique 1 selon le premier aspect de l'invention. Des étapes de différents modes de mise en œuvre de ce procédé sont illustrées sur les figures 9 à 15.

Un troisième aspect de l'invention concerne un écran d'affichage ou un système de projection d'au moins une image comprenant au moins un dispositif optoélectronique 1 selon le premier aspect de l'invention. Le troisième aspect de l'invention n'est pas illustré sur les figures, mais il est réputé immédiat pour la personne du métier de savoir comment le dispositif optoélectronique 1 selon le premier aspect de l'invention est destiné à intégrer un écran d'affichage ou un système de projection d'images.

### L'empilement 11

La figure 9 illustre un mode de réalisation de l'empilement 11. Il est à noter ici que l'illustration offerte par la figure 9 est simplifiée structurellement. Elle est toutefois jugée suffire à illustrer la façon dont l'empilement 11 est agencé relativement aux autres éléments de chacun des modes de réalisation du dispositif optoélectronique 1. La personne du métier est jugée connaître, de par ses connaissances générales, au moins une, voire plusieurs, des structures complexes que peut prendre l'empilement 11.

Notamment en référence à cette figure 9, l'empilement 11 comprend une pluralité de diodes électroluminescentes 111 et une pluralité de plots électriquement conducteurs 112. Les diodes électroluminescentes 111 de la pluralité sont disposées à distance les unes des autres. Les diodes électroluminescentes 111 de la pluralité sont de préférence disposées sur un même niveau du dispositif optoélectronique 1. Les plots électriquement conducteurs 112 de la pluralité sont disposés entre les diodes électroluminescentes 111 et s'étendent au travers d'une couche de collage 114 qui interface la jonction P-N de chaque diode électroluminescente 111 avec un substrat 113 sous-jacent, de préférence directement. Les plots électriquement conducteurs 112 sont de préférence disposés sur un même niveau du dispositif optoélectronique 1. De préférence, chaque plot électriquement conducteur 112 est entouré de diodes électroluminescentes 111, ou inversement. Chaque plot 112 et/ou chaque diode électroluminescente 111 se présente par exemple sous la forme d'un parallélépipède sensiblement rectangle ou celle d'un cylindre sensiblement droit. Les diodes électroluminescentes 111 et les plots électriquement conducteurs 112 peuvent par exemple être disposés en damier, sans pour autant nécessiter que les diodes électroluminescentes 111 et les plots électriquement conducteurs 112 présentent de mêmes dimensions, notamment transverses ; les figures illustrent d'ailleurs, de façon tout aussi non limitative, des plots 112 présentant une dimension en largeur différente de celle des diodes électroluminescentes 111. Par ailleurs, notons ici que les plots électriquement conducteurs 112 peuvent être à base, voire constitués de, un métal conducteur tel que le cuivre ou l'aluminium.

Toujours en référence à la figure 9, chaque diode électroluminescente 111 peut être une source de lumière pour un sous-pixel. Plus particulièrement, chaque diode électroluminescente 111 peut comprendre une couche semi-conductrice de premier type 111a, une couche électroluminescente 111b, aussi appelée couche active, et une couche semi-conductrice de second type 111c, qui sont empilées dans cet ordre. La couche électroluminescente 111b est prise en sandwich entre la couche semi-conductrice de premier type 111a et la couche semi-conductrice de deuxième type 111c. Par exemple, la couche semi-conductrice de premier type 111a est un semi-conducteur de type P, la couche semi-conductrice de deuxième type 111c est un semi-conducteur de type N, et la couche électroluminescente 112 est de préférence une couche à puits quantiques multiples ou couche MQW (pour « multiple quantum well » en anglais), mais cette description ne se limite pas à cet exemple. En alternative, la couche semi-conductrice de premier type 111a peut être un semi-conducteur de type N, et la couche semi-conductrice de second type 111c peut être un semi-conducteur de type P.

Les diodes électroluminescentes 111 sont typiquement adaptées à émettre de la lumière bleue, c'est-à-dire un rayonnement dont la longueur d'onde se situe dans la plage allant sensiblement de 430 nm à 480 nm.

Plus particulièrement, l'empilement 11 peut comprendre en outre :
a. un substrat porteur 113,
b. une couche d'interfaçage 114 s'étendant sur le substrat porteur 113 entre les plots électriquement conducteurs 112, et
c. une matrice de structures émissives 1112 s'étendant, de préférence directement, sur la couche d'interfaçage 114 entre les plots électriquement conducteurs 112.

Le substrat porteur 113 peut comprendre au moins un circuit-intégré propre à une application (ou ASIC acronyme de l'anglais « application-specific integrated circuit »). Le substrat porteur 113 peut comprendre au moins un plot de connexion électrique 115 entre ledit circuit-intégré et au moins une, par exemple plusieurs, des diodes électroluminescentes 111. La couche d'interfaçage 114 s'étend entre paires d'ensembles adjacents formés des plots électriquement conducteurs 112 et de parois diélectriques 117 latérales (décrites plus en détails ci-après). La couche d'interfaçage 114 peut être constituée d'au moins une couche en un matériaux métalliques et plus typiquement d'un empilement de couches en matériaux métalliques.

Chaque diode électroluminescente 111 s'étend sur la couche d'interfaçage 114. Chaque plot de connexion électrique 115 peut former un via 115 d'interconnexion électrique entre le substrat porteur 113 et la diode électroluminescente 111 le surplombant, par l'intermédiaire de la couche d'interfaçage 114. Les vias 115 sont de préférence situés dans une couche supérieure d'oxyde (non représentée sur les figures) du substrat porteur 113.

Le substrat porteur peut par exemple être de type CMOS, et donc, dans cet exemple, les vias 115 sont de préférence situés au-dessus des derniers niveaux métalliques du CMOS.

La couche d'interfaçage 114 constitue de préférence une interface de collage conductrice entre le substrat porteur 113 et la matrice de structures émissives 1112. La couche d'interfaçage 114 assure la conduction électrique entre l'ASIC (situé dans le substrat porteur 113) et chaque diode électroluminescente 111 via les vias 115.

La matrice de structures émissives 1112 comprend au moins la pluralité de diodes électroluminescentes 111 et la pluralité de plots électriquement conducteurs 112. Cette matrice 1112 forme de préférence un niveau de chacun des modes de réalisation du dispositif optoélectronique 1 selon le premier aspect de l'invention.

Au moins une, de préférence chaque, structure émissive 1112 comprend au moins une diode électroluminescente 111 et au moins une partie de chacun des plots électriquement conducteurs 112 adjacents, isolés au moins partiellement entre eux électriquement par la paroi diélectrique 117 susmentionnée.

L'empilement 11 peut comprendre en outre une couche d'électrode 116. Cette dernière est de préférence à base d'un matériau non seulement conducteur électrique, mais également transparent, au moins aux longueurs d'onde émises par les diodes électroluminescentes 111 qu'elle recouvre. La couche d'électrode 116 est ainsi adaptée à laisser passer au moins une partie significative du rayonnement électromagnétique émis, ou équivalemment la lumière émise, par les diodes électroluminescentes 111. La couche d'électrode 116 s'étend, le cas échéant continûment, entre d'une part la couche de confinement de lumière 12 qui sera décrite plus bas (Cf. par exemple Fig. 1) et d'autre part les pluralités de diodes électroluminescentes 111 et de plots électriquement conducteurs 112.

Le matériau formant la couche d'électrode 116 peut être un matériau transparent conducteur (MTC) qui est un solide qui n'absorbe pas la lumière visible (gap supérieur à 3 eV) et qui présente une bonne conductivité électrique, de l'oxyde d'indium-étain (ou ITO, acronyme anglais pour Indium Tin Oxide), de l'oxyde de zinc dopé à l'aluminium ou au gallium, du graphène, de l'aluminium (de préférence d'une épaisseur sensiblement égale à 10 nm), de l'oxyde de zinc dopé à l'aluminium (AZO), ou une combinaison de ces matériaux. L'épaisseur de la couche d'électrode 116 peut être comprise entre 0,03 µm et 1 µm. Il est à noter que la présence d'une couche d'électrode 116 dans l'empilement 11 est optionnelle, notamment dans la mesure où un contact électrique latéral 1171 peut être prévu sur lequel nous reviendrons plus bas.

Au moins une, de préférence chaque, structure émissive 1112 peut comprendre en outre au moins une paroi d'isolation électrique ou paroi diélectrique 117. Le cas échéant, la paroi diélectrique 117 assure une isolation électrique entre les éléments qu'elle sépare, et notamment :
a. entre au moins un plot électriquement conducteur 112 et le substrat porteur 113, et plus particulièrement entre au moins un plot électriquement conducteur 112 et chaque couche d'interfaçage 114 adjacente, et/ou
b. entre au moins un plot électriquement conducteur 112 et au moins une, de préférence chaque, diode électroluminescente 111 adjacente, pour éviter de mettre en court-circuit au moins une zone p ou n des jonctions P-N des diodes électroluminescentes.

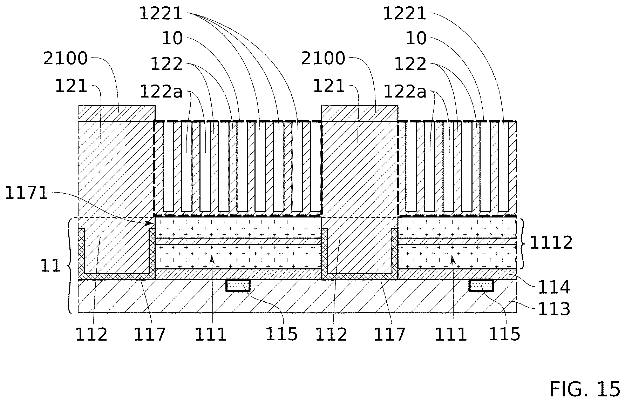

L'isolation électrique assurée par la paroi diélectrique 117 peut n'être que partielle, notamment dès lors que le dispositif optoélectronique 1 ne comprend pas la couche d'électrode 116 susmentionnée. Il est en effet au moins préférable que, dans ce cas, un contact électrique latéral 1171 (Cf. par exemple figure 15) subsiste entre un, voire chaque, plot électriquement conducteur 112 de la pluralité et la couche semi-conductrice de deuxième type 111c d'au moins une, de préférence de chacune, des diodes électroluminescentes 111 adjacentes.

Plus particulièrement, au moins une, de préférence chaque, structure émissive comprend en outre des parois diélectriques 117 dont des premières parois diélectriques 117a s'étendant entre au moins un, de préférence chaque, plot conducteur 112 et le substrat porteur 113 et des secondes parois diélectriques 117b, dites latérales, s'étendant sur au moins une partie des côtés latéraux de chaque plot conducteur 112, les première et seconde parois diélectriques 117a et 177b étant de préférence jointes entre elles, de sorte que chaque plot conducteur soit isolé électriquement sur une partie de son pourtour.

### La couche de confinement de lumière 12

En référence aux figures 1 à 8 et 18, la couche de confinement de lumière 12 s'étend sur l'empilement 11. Elle comprend des parois réfléchissantes 121. Ces dernières sont de préférence situées au droit des plots électriquement conducteurs 112, et non au droit des diodes électroluminescentes 111, de sorte à ne pas s'opposer au passage de la lumière émise par les diodes électroluminescentes 111, et au contraire de sorte à réfléchir la lumière émise par les diodes électroluminescentes 111 et réduire ainsi les phénomènes de diaphonie optique.

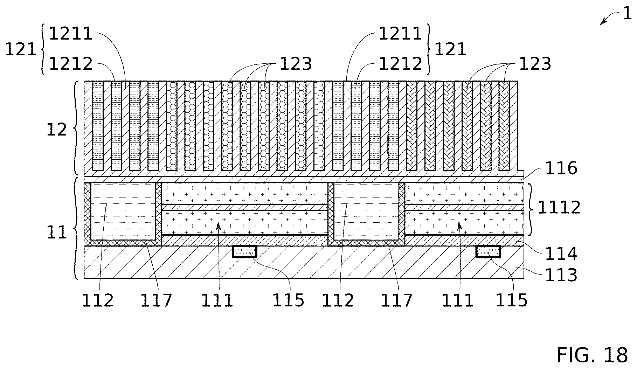

Comme illustré sur la figure 18, l'une au moins, potentiellement chaque, paroi réfléchissante 121 est à base d'alumine poreuse 1211 et d'un matériau réfléchissant ou absorbant 1212 situé dans les pores de l'alumine poreuse 1211 ; ce mode de réalisation permet de profiter de la nature fortement anisotrope de l'anodisation de l'aluminium en alumine nanoporeuse pour obtenir des parois 121 encore plus réfléchissantes et/ou plus absorbantes, selon la nature du matériau remplissant les pores.

Comme l'illustre notamment la figure 1, les parois réfléchissantes 121, quelle que soit leur constitution, définissent ou délimitent entre elles des espaces 10, ou équivalemment des volumes, situés chacun au droit d'au moins une diode électroluminescente 111. Plus particulièrement, chaque espace 10 peut être situé au droit d'un pixel comprenant le cas échéant plusieurs diodes électroluminescentes 111 ou d'un sous-pixel comprenant par exemple une seule diode électroluminescente 111. Et les parois réfléchissantes 121 définissant ledit espace 10 s'étendent au droit de certains au moins, de préférence de chacun, des plots électriquement conducteurs 112 adjacents à ladite au moins une diode électroluminescente 111 au droit de laquelle l'espace 10 est situé.

C'est dans certains au moins des espaces 10, potentiellement dans chacun de ces espaces 10, que de l'alumine poreuse 122 est formée.

Le dispositif optoélectronique 1 selon certains de ses différents modes de réalisation qui sont illustrés sur les figures 1, 2, 5, 6, 17 et 18 est tel que la couche de confinement de lumière 12 comprend effectivement de l'alumine poreuse 122 dans au moins certains desdits espaces 10, l'alumine poreuse 122 présentant, dans au moins un espace, de préférence au moins deux espaces, voire dans chaque espace, parmi lesdits au moins certains desdits espaces, au moins deux pores 1221 ouverts sur une première face 12a de la couche de confinement 12 qui est située à l'opposé de l'empilement 11. Notons que les modes de réalisation qui sont illustrés sur les figures 1, 2, 5, 6, 17 et 18 constituent tout ou partie de produits finaux, par opposition à des produits intermédiaires.

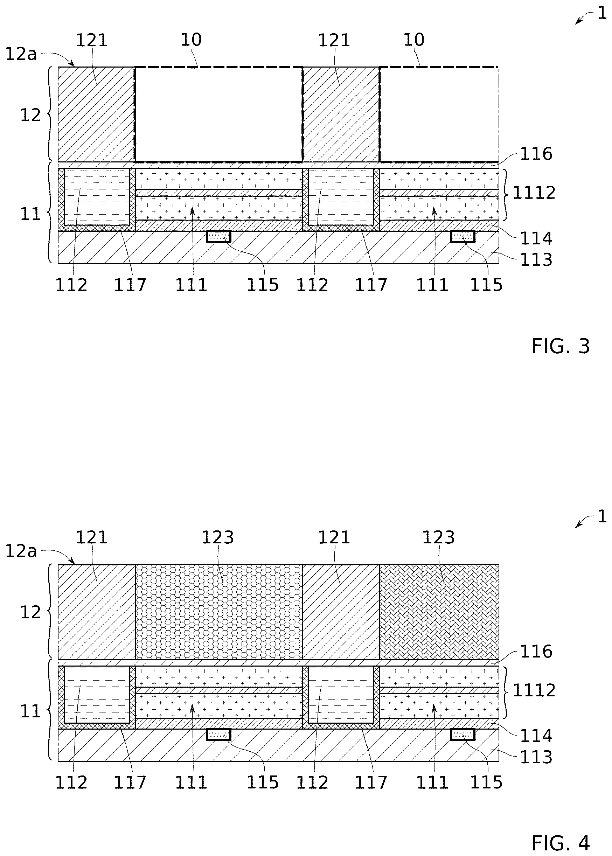

Les modes de réalisation qui sont illustrés sur les figures 3, 4, 7 et 8 peuvent également être considérés comme des produits finaux et peuvent ne pas comprendre d'alumine poreuse 122 au droit de certains desdits espaces 10. Ces modes de réalisation sont de préférence fabriqués à partir de dispositifs optoélectroniques tels que ceux illustrés sur les figures 1, 3, 7, et 17, en tant que produits intermédiaires, l'alumine poreuse 122 de ces produits intermédiaires présentant l'avantage d'être aisée à graver pour la retirer en tout ou partie, localement ou partout.

Les pores 1221 de l'alumine poreuse 122 située au droit des espaces 10, qu'ils soient ceux des produits finaux ou des produits intermédiaires susmentionnés, présentent de préférence des dimensions transversales comprises entre 1 et 500 nm et de préférence entre 50 et 400 nm. En alternative ou en complément à la préférence précédente, les pores 1221 de l'alumine poreuse 122 présentent de préférence une périodicité comprise entre 200 et 700 nm. Par ailleurs, la taille des pores est de préférence supérieure à la dimension des particules de conversion de couleur que l'on souhaite glisser à l'intérieur, de sorte à pouvoir avoir au moins une particule de conversion de couleur dans chaque pore. La dimension transversale des pores 1221 peut donc dépendre de la taille des particules du matériau de conversion de couleur de lumière qui sont destinées à y être introduites ; les paramètres de l'anodisation de la couche d'aluminium pour former l'alumine poreuse sont de préférence définis en conséquence.

L'alumine poreuse 122 situé le cas échéant au droit des plots électriquement conducteurs 112 peut présenter les mêmes caractéristiques que celles énoncées ci-dessus pour qualifier l'alumine poreuse 122 située dans certains au moins des espaces 10.

Différents matériaux sont susceptibles de constituer lesdites particules du matériau de conversion de couleur de lumière. Par exemple :
a. des boîtes quantiques,
b. des agrégats de couplage d'absorbeurs et de convertisseurs de lumière (ou « J-aggregates » en anglais),
c. des nanoparticules phosphorescentes (ou fluorescentes), et
d. des pérovskites,
le cas échéant mis(es) en solution dans un solvant ou incorporé(es) dans une résine, sont envisagés en tant que particules faites d'un matériau de conversion de couleur de lumière. Ces particules peuvent présenter des tailles caractéristiques différentes les unes des autres et la personne du métier est censée savoir paramétrer l'anodisation par laquelle l'alumine poreuse 122 est formée pour obtenir des pores 1221 ouverts qui permettent d'y introduire au moins une telle particule, de préférence plusieurs telles particules.
Il est à noter que le solvant dans lequel lesdites particules peuvent être mises en solution peut n'être présent qu'au moment du dépôt de ces particules dans les pores 1221, car une étape subséquente de séchage peut avantageusement permettre de venir évaporer ledit solvant qui ne se trouve alors plus dans le dispositif optoélectronique 1 selon le premier aspect de l'invention.

Le matériau de conversion de couleur de lumière 123 est de préférence greffé aux parois internes de pores 1221. Le solvant ou la résine susmentionnés peuvent jouer un rôle avantageux dans la formation de telles greffes. Mais, plus généralement, les particules du matériau de conversion de couleur de lumière 123 et/ou les parois internes des pores 1221 peuvent être fonctionnalisés, avant, voire pendant, le dépôt du matériau de conversion de couleur de lumière 123 dans les pores 1221 de l'alumine poreuse 122, de sorte à obtenir un greffage des unes aux autres, par exemple par des liaisons hydrogènes -OH de surface, créées le cas échéant par un traitement avec une chimie alcaline ou par un traitement par plasma sec ou par adsorption d'un ligand.

Au moins un, de préférence chaque, pore 1221 ouvert sur la première face 12a de la couche de confinement 12 qui est située à l'opposé de l'empilement 11 présente de préférence un taux de remplissage, en le matériau de conversion de couleur de lumière, sensiblement égale à 30%. L'atteinte d'un tel remplissage peut être rendue aisée par le greffage susmentionné.

### Le dispositif optoélectronique 1

La couche 12 est nommée couche de confinement de lumière car c'est là sa fonction principale, mais, comme nous l'avons vu plus haut, elle peut également remplir une fonction de conversion de couleur ; aussi elle aurait pu être appelée, pour au moins certains des modes de réalisation qui sont notamment illustrés sur les figures 2, 4, 6, 8 et 18, « couche de confinement et de conversion de lumière 12 ».

Les diodes électroluminescentes 111 peuvent être configurées pour émettre une lumière d'une première longueur d'onde déterminée, par exemple la couleur bleu, selon une direction sensiblement perpendiculaire à la première face 12a de la couche de confinement 12.

En complément ou en alternative, le matériau de conversion de couleur de lumière 123 peut être propre à convertir la lumière émise à la première longueur d'onde en une lumière présentant une deuxième longueur d'onde différente de la première, par exemple la première longueur d'onde étant située dans le bleu et la deuxième longueur d'onde étant située dans l'un ou l'autre parmi le vert et le rouge. Selon un mode de réalisation, la lumière verte ainsi convertie est d'une longueur d'onde située sensiblement dans la plage allant de 510 nm à 570 nm. Selon un mode de réalisation, la lumière rouge ainsi convertie est d'une longueur d'onde située sensiblement dans la plage allant de 600 nm à 720 nm.

Comme l'illustrent les figures 1, 2, 5, 6 et 18, les pores 1221 de l'alumine poreuse 122 forment des canaux 122a débouchant sur la première face 12a de la couche de confinement 12. Les canaux 122a s'étendent de préférence principalement selon une direction perpendiculaire à la première surface 12a de la couche de confinement 12 ; ils peuvent plus particulièrement s'étendre sur une distance Lp, prise en projection selon une direction perpendiculaire à la première face 12a, strictement supérieure à une moitié d'une épaisseur E12 de la couche de confinement 12. Plus particulièrement, les pores 1221 peuvent s'étendre sensiblement jusqu'à l'empilement 11, de préférence sans pour autant l'atteindre (sauf en présence des plots d'aluminium au-dessus des plots conducteurs, ces plots d'aluminium prévenant la délamination de la structure), de sorte à limiter tout risque de délamination, pour présenter une surface de parois internes maximisée, et maximiser ainsi le greffage susmentionné, et par voie de conséquence le remplissage des pores par le matériau de conversion de couleur de lumière 123. Ainsi, au moins un, de préférence chaque, pore 1221 peut présenter un facteur de forme défini par des dimensions transversales sensiblement comprises entre 40 nm et 800 nm, et/ou une dimension longitudinale sensiblement comprise entre 500 nm et 10 µm, de préférence sensiblement comprise entre 1 µm et 5 µm.

La combinaison desdits au moins deux pores 1221, voire desdits au moins huit pores 1221, ou des au moins un pore tous les 2×λ, où λ représente la longueur d'onde à extraire et au moins quatre pores par espace (cas pixel de 1µm), au droit d'une même diode électroluminescente 111, et d'un remplissage des pores 1221 avec un matériau de conversion de couleur de lumière 123 permet d'atteindre une augmentation du taux de conversion par synergie avec l'augmentation de la diffusion provoquée par la pluralité de pores au droit d'une même diode électroluminescente 111, tout en bénéficiant d'une diminution des phénomènes de diaphonie optique par synergie avec les parois réfléchissantes 121.

Comme déjà mentionné plus haut, et comme ce sera le cas des produits finaux illustrés sur les figures 3, 4 et 8, la couche de confinement de lumière 12 peut être exempte d'alumine poreuse 122 dans au moins un, potentiellement dans plusieurs, desdits espaces 10, de l'alumine poreuse 122 étant tout de même située dans au moins un des espaces 10. Alors, au moins un, de préférence chaque, espace 10 exempt d'alumine poreuse 122 peut être laissé 'vide', comme illustré sur la figure 3, ou, au contraire, être avantageusement rempli d'un matériau de conversion de couleur de lumière 123, comme illustré sur la figure 4. Le matériau de conversion de couleur de lumière 123 peut dans ce dernier cas être choisi parmi ceux susmentionnés pour venir remplir les pores 1221.

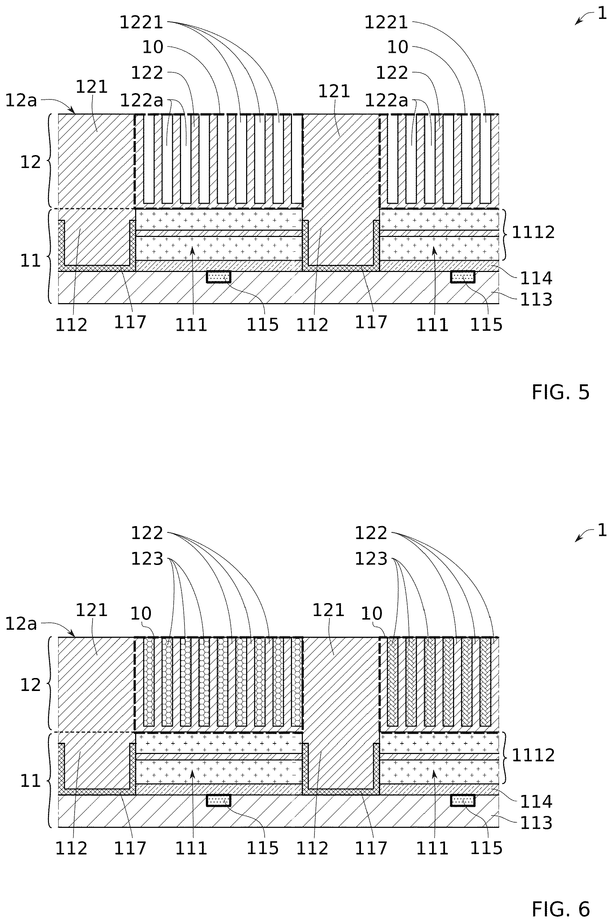

Comme vu plus haut, au moins un plot électriquement conducteur 112 et la paroi réfléchissante 121 située au droit dudit au moins un plot électriquement conducteur peuvent être à base, voire constitué, d'aluminium ; ils peuvent alors former ensemble un volume de matière homogène (ou « bulk » en anglais), notamment en l'absence de la couche d'électrode 116, comme cela est illustré sur les figures 5, 6, 7 et 8. Les plots électriquement conducteurs 112 peuvent ainsi être avantageusement réalisés dans un même matériau que celui à base duquel les parois réfléchissantes 121 sont constituées, ce qui simplifie le dispositif 1 et son procédé de fabrication, notamment en évitant une étape technologique de dépôt, par exemple par électrodépôt (ou « electrodeposition » en anglais), de plots électriquement conducteurs 121 à base d'un autre matériau métallique que l'aluminium, par exemple à base de cuivre.

### Procédé de fabrication

Des caractéristiques liées à la mise en œuvre du procédé de fabrication selon le deuxième aspect de l'invention d'un mode de réalisation d'un dispositif optoélectronique selon le premier aspect de l'invention ont déjà été introduites ci-dessus.

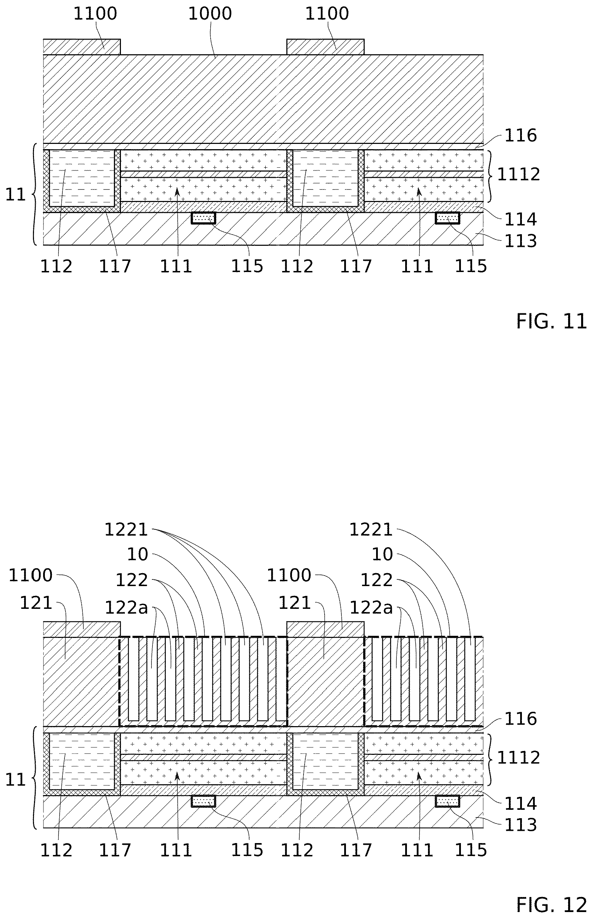

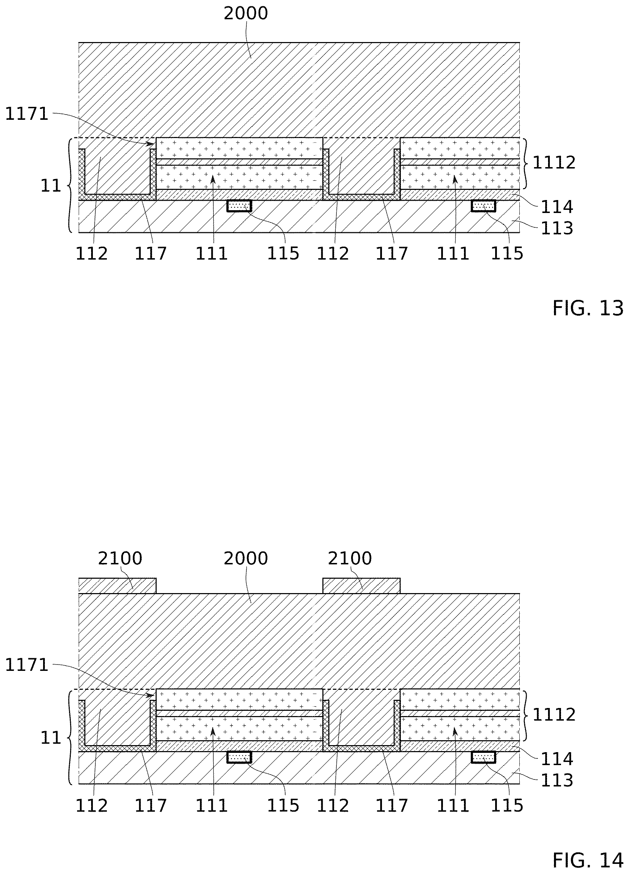

Néanmoins, notons que le procédé de fabrication selon le deuxième aspect de l'invention comprend les étapes suivantes :
a. fournir un empilement 11, par exemple tel qu'illustré sur la figure 9, comprenant :
   i. une pluralité de diodes électroluminescentes 111 à jonction P-N disposées à distance les unes des autres, et
   ii. une pluralité de plots électriquement conducteurs 112 disposés entre les diodes électroluminescentes,

les plots électriquement conducteurs 112 étant isolés électriquement d'au moins une zone p ou n des jonctions P-N des diodes électroluminescentes 111, pour éviter un court-circuit,
   b. former, sur l'empilement 11, une couche de confinement de lumière 12 comprenant des parois réfléchissantes 121 définissant entre elles des espaces 10 situés chacun au droit d'une diode électroluminescente 111, par dépôt d'une couche à base d'aluminium 1000, 2000, comme illustré sur les figures 10 et 13, sur une face principale 11a de l'empilement 11 par laquelle les diodes électroluminescentes 111 sont configurées pour émettre, puis
   c. anodisation de la couche à base d'aluminium 1000, 2000 au moins en dehors de zones situées au droit des plots conducteurs 112 de l'empilement 11, pour obtenir par exemple les structures illustrées en figures 11 et 12, et 14 et 15, respectivement,
le procédé de fabrication selon le deuxième aspect de l'invention étant essentiellement tel que l'anodisation est, comme déjà annoncé plus haut, paramétrée de sorte que de l'alumine poreuse 122 soit formée dans au moins certains desdits espaces 10, en présentant, dans au moins un espace, de préférence au moins deux espaces, voire dans chaque espace, parmi lesdits au moins certains desdits espaces 10, au moins deux pores 1221 ouverts sur une première face 12a de la couche de confinement 12 qui est située à l'opposé de l'empilement 11.

Une première mise en œuvre du procédé de fabrication selon le deuxième aspect d'un mode de réalisation du dispositif optoélectronique 1 selon le premier aspect de l'invention qui est illustré sur la figure 1 est décrit ci-dessous à titre illustratif en référence aux figures 10 à 12. On y observe respectivement le dépôt de la couche d'aluminium 1000 d'épaisseur E12 sur l'empilement 11, et plus particulièrement sur la couche d'électrode 116 de l'empilement 11, puis l'anodisation localisée, grâce à des masques 1100, des zones de la couche d'aluminium 1000 qui se situent au droit des diodes électroluminescentes 111, pour parvenir à un dispositif optoélectronique tel qu'illustré sur la figure 12, auquel il suffit de retirer les masques 1100 pour obtenir le dispositif optoélectronique tel qu'illustré sur la figure 1. Les pores 1221 ainsi formés peuvent ensuite être remplis d'un matériau de conversion de couleur de lumière 123 tel que détaillé ci-dessus pour obtenir le dispositif optoélectronique tel qu'illustré sur la figure 2. Notons que l'anodisation se fait aussi en partie sous le masque. Par conséquent, la taille du masque est de préférence inférieure à la dimension de la cavité nanoporeuse ; Plus l'épaisseur à anodiser va être importante et a priori plus cet effet va être présent.

Une deuxième mise en œuvre du procédé de fabrication selon le deuxième aspect de l'invention d'un mode de réalisation du dispositif optoélectronique 1 selon le premier aspect de l'invention qui est illustré sur la figure 5 est décrit ci-dessous à titre illustratif en référence aux figures 13 à 15. On y observe respectivement le dépôt des plots électriquement conducteurs 112 entre les diodes électroluminescentes 111 pour finaliser l'empilement 11, qui est exempt d'une couche d'électrode 116. Ensuite, ce dépôt est prolongé pour former la couche d'aluminium 2000 d'épaisseur E12 sur l'empilement 11, puis l'anodisation localisée, grâce à des masques 2100, des zones de la couche d'aluminium 2000 qui se situent au droit des diodes électroluminescentes 111, pour parvenir à un dispositif optoélectronique tel qu'illustré sur la figure 15, auquel il suffit de retirer les masques 2100 pour obtenir le dispositif optoélectronique tel qu'illustré sur la figure 5. Les pores 1221 ainsi formés peuvent ensuite être remplis d'un matériau de conversion de couleur de lumière 123 tel que détaillé ci-dessus pour obtenir le dispositif optoélectronique tel qu'illustré sur la figure 6.

A noter, en écho à ce qui a déjà été décrit plus haut, que l'étape d'anodisation susmentionnée comprend en outre l'anodisation, de préférence simultanée, d'une partie de la couche à base d'aluminium 1000, 2000 qui est située au droit d'au moins un plot électriquement conducteur 112. Le procédé de fabrication selon l'invention comprend en outre le dépôt d'un matériau réfléchissant 1212 (ou absorbant) dans les pores de l'alumine poreuse 1211 située au droit dudit au moins un plot électriquement conducteur 112.

L'invention n'est pas limitée aux modes de réalisation précédemment décrits ou aux mises en œuvre précédemment décrites, mais est définie par les revendications attenantes.

## Revendications

1. Dispositif optoélectronique (1) comprenant :
• un empilement (11) comprenant :
i. une pluralité de diodes électroluminescentes (111) à jonction P-N disposées à distance les unes des autres, et
ii. une pluralité de plots électriquement conducteurs (112) disposés entre les diodes électroluminescentes (111),
les plots électriquement conducteurs (112) étant isolés électriquement d'au moins une zone p ou n des jonctions P-N des diodes électroluminescentes, et
• une couche de confinement de lumière (12) s'étendant sur l'empilement (11) et comprenant des parois réfléchissantes (121) définissant entre elles des espaces (10) situés chacun au droit d'au moins une, de préférence de chaque, diode électroluminescente (111),
le dispositif optoélectronique (1) étant tel que la couche de confinement de lumière (12) comprend en outre de l'alumine poreuse (122) dans au moins certains desdits espaces (10), l'alumine poreuse (122) présentant, dans au moins un espace, de préférence au moins deux espaces, voire dans chaque espace, parmi lesdits au moins certains desdits espaces, au moins deux pores (1221) ouverts sur une première face (12a) de la couche de confinement (12) qui est située à l'opposé de l'empilement (11), le dispositif optoélectronique (1) étant caractérisé au moins en ce que l'une au moins, potentiellement chaque, paroi réfléchissante (121) est à base d'alumine poreuse (1211) et d'un matériau réfléchissant (1212) situé dans les pores de l'alumine poreuse (1211).

2. Dispositif optoélectronique (1) selon la revendication précédente, dans lequel les pores (1221) de l'alumine poreuse (122) présentent des dimensions transversales comprises entre 1 et 500 nm et de préférence entre 50 et 400 nm, et dans lequel les pores (1221) de l'alumine poreuse (122) présentent une périodicité comprise entre 200 et 700 nm.

3. Dispositif optoélectronique (1) selon l'une quelconque des revendications précédentes, dans lequel l'alumine poreuse (122) présente, dans au moins un espace, de préférence au moins deux espaces, voire dans chaque espace, parmi lesdits au moins certains desdits espaces, au moins huit pores (1221) ouverts sur la première face (12a) de la couche de confinement (12) qui est située à l'opposé de l'empilement.

4. Dispositif optoélectronique (1) selon l'une quelconque des revendications précédentes, dans lequel les pores (1221) de l'alumine poreuse (122) forment des canaux (122a) débouchant sur la première face (12a) de la couche de confinement (12).

5. Dispositif optoélectronique (1) selon l'une quelconque des revendications précédentes, dans lequel au moins certains des pores (1221) présentent une dimension Lp en longueur, prise en projection selon une direction perpendiculaire à la première face (12a), au plus égale, et de préférence strictement inférieure, par exemple de 2 nm, à une épaisseur de la couche de confinement de lumière (12).

6. Dispositif optoélectronique (1) selon l'une quelconque des revendications précédentes, dans lequel les pores (1221) s'étendent sensiblement jusqu'à l'empilement (11).

7. Dispositif optoélectronique (1) selon l'une des revendications 1 et 3-6, dans lequel au moins un pore (1221) présente un facteur de forme défini par des dimensions transversales sensiblement comprises entre 40 nm et 800 nm, et/ou une dimension longitudinale sensiblement comprise entre 500 nm et 10 µm, de préférence sensiblement comprise entre 1 µm et 5 µm.

8. Dispositif optoélectronique (1) selon l'une quelconque des revendications précédentes, dans lequel les pores ouverts (1221) sur la première face de la couche de confinement (12) occupent une surface sensiblement égale à 30% de la surface totale de cette couche de confinement et/ou les pores ouverts (1221) au-dessus d'au moins une diode électroluminescente (111) qui sont adjacents entre eux sont distants deux à deux, par leurs centres, d'une distance sensiblement égale à une longueur d'onde de la lumière émise par la diode électroluminescente (111) sous-jacente, cette longueur d'onde appartenant typiquement au spectre de lumière bleue, soit par exemple entre 380 et 450 nm.

9. Dispositif optoélectronique (1) selon l'une quelconque des revendications précédentes, dans lequel l'empilement (11) comprend en outre :
• un substrat porteur (113) et
• une matrice de structures émissives (1112) s'étendant sur le substrat porteur (113),
la matrice de structures émissives (1112) comprenant la pluralité de diodes électroluminescentes (111) qui s'étendent sur le substrat porteur (113) par l'intermédiaire d'une couche d'interfaçage (114) et la pluralité de plots électriquement conducteurs qui s'étend optionnellement sur le substrat porteur (113) par l'intermédiaire d'une paroi d'isolation électrique (117).

10. Dispositif optoélectronique (1) selon l'une quelconque des revendications précédentes, comprenant en outre un matériau de conversion de couleur de lumière (123) situé dans les pores (1221) de l'alumine poreuse (122) située au droit d'au moins une diode électroluminescente (111), de préférence au droit de chaque diode électroluminescente.

11. Dispositif optoélectronique (1) selon la revendication précédente, dans lequel au moins un, de préférence chaque, pore (1221) ouvert sur la première face (12a) de la couche de confinement (12) qui est située à l'opposé de l'empilement (11) présente un taux de remplissage, en le matériau de conversion de couleur de lumière, sensiblement égale à 30%.

12. Dispositif optoélectronique (1) selon la revendication 10, dans lequel la couche de confinement de lumière (12) est exempte d'alumine poreuse (122) dans au moins un, potentiellement dans plusieurs, desdits espaces (10).

13. Procédé de fabrication d'un dispositif optoélectronique (1) comprenant les étapes suivantes :
• fournir un empilement (11) comprenant :
i. une pluralité de diodes électroluminescentes (111) à jonction P-N disposées à distance les unes des autres, et
ii. une pluralité de plots électriquement conducteurs (112) disposés entre les diodes électroluminescentes,
les plots électriquement conducteurs étant isolés électriquement d'au moins une zone p ou n des jonctions P-N des diodes électroluminescentes,
• former, sur l'empilement (11), une couche de confinement de lumière (12) comprenant des parois réfléchissantes (121) définissant entre elles des espaces (10) situés chacun au droit d'une diode électroluminescente (111), par
i. dépôt d'une couche à base d'aluminium (1000, 2000) sur une face principale (11a) de l'empilement (11) par laquelle les diodes électroluminescentes (111) sont configurées pour émettre, puis
ii. anodisation de la couche à base d'aluminium (1000, 2000) au moins en dehors de zones situées au droit des plots conducteurs (112) de l'empilement (11),
• l'anodisation étant paramétrée de sorte que de l'alumine poreuse (122) soit formée dans au moins certains desdits espaces (10), en présentant, dans au moins un espace, de préférence au moins deux espaces, voire dans chaque espace, parmi lesdits au moins certains desdits espaces (10), au moins deux pores (1221) ouverts sur une première face (12a) de la couche de confinement (12) qui est située à l'opposé de l'empilement (11)
le procédé étant **caractérisé en ce que**,
l'étape d'anodisation comprend l'anodisation d'une partie de la couche à base d'aluminium (1000, 2000) qui est située au droit d'au moins un plot électriquement conducteur (112) et comprenant en outre le dépôt d'un matériau réfléchissant (1212) dans les pores de l'alumine poreuse (1211) située au droit dudit au moins un plot électriquement conducteur (112).

14. Procédé de fabrication selon la revendication précédente, dans lequel l'étape d'anodisation de la couche à base d'aluminium (1000, 2000) est paramétrée de sorte que l'alumine poreuse (122) forment des canaux (122a) débouchant par les pores (1221) ouverts sur la première face (12a) de la couche de confinement (12), et de préférence de sorte qu'au moins un canal (122a), par exemple chaque canal, présente des dimensions transversales sensiblement comprises entre 40nm et 800nm, et/ou une dimension longitudinale sensiblement comprise entre 500 nm et 10 µm, de préférence sensiblement comprise entre 1µm et 6µm.

15. Ecran d'affichage ou système de projection d'au moins une image comprenant au moins un dispositif optoélectronique (1) selon l'une quelconque des revendications 1 à 12.

## Patentansprüche

1. Optoelektronische Anordnung (1), die Folgendes umfasst:
• eine Stapelung (11), die Folgendes umfasst:
i. eine Vielzahl von Leuchtdioden (111) mit P-N-Übergang, die voneinander beabstandet angeordnet sind, um
ii. eine Vielzahl elektrisch leitfähiger Kontaktstücke (112), die zwischen den Leuchtdioden (111) angeordnet sind,
wobei die elektrisch leitfähigem Kontaktstücke (112) elektrisch von mindestens einer p- oder n-Zone der P-N-Übergänge der Leuchtdioden isoliert sind, und
• eine Lichteinschlussschicht (12), die sich auf der Stapelung (11) erstreckt und reflektierende Wände (121) umfasst, die zwischen einander Räume (10) definieren, die sich jeweils in Ausrichtung mit mindestens einer, bevorzugt jeder Leuchtdiode (111) befinden,
wobei die optoelektronische Vorrichtung (1) derart ist, dass die Lichteinschlussschicht (12) außerdem poröses Aluminiumoxid (122) in mindestens einigen der Räume (10) umfasst, wobei das poröse Aluminiumoxid (122) in mindestens einem Raum, bevorzugt in mindestens zwei Räumen, ja sogar in jedem Raum unter den mindestens einigen Räumen, mindestens zwei Poren (1221) aufweist, die auf einer ersten Fläche (12a) der Einschlussschicht (12), die der Stapelstruktur (11) entgegengesetzt ist, hin offen sind, wobei die optoelektronische Vorrichtung (1) mindestens **dadurch gekennzeichnet ist, dass** mindestens eine, potenziell jede reflektierende Wand (121) auf porösem Aluminiumoxid (1211) und einem reflektierenden Material (1212) basiert, das sich in den Poren des porösen Aluminiumoxids (1211) befindet.

2. Optoelektronische Vorrichtung (1) nach dem vorstehenden Anspruch, wobei die Poren (1221) des porösen Aluminiumoxids (122) Querabmessungen aufweisen, die zwischen 1 und 500 nm und bevorzugt zwischen 50 und 400 nm betragen, und wobei die Poren (1221) des porösen Aluminiumoxids (122) eine Periodizität zwischen 200 und 700 nm aufweisen.

3. Optoelektronische Vorrichtung (1) nach einem der vorstehenden Ansprüche, wobei das poröse Aluminiumoxid (122) in mindestens einem Raum, bevorzugt in mindestens zwei Räumen, ja sogar in jedem Raum unter den mindestens bestimmten der Räume mindestens acht offene Poren (1221) auf der ersten Fläche (12a) der Einschlussschicht (12), die der Stapelung entgegengesetzt liegt, aufweist.

4. Optoelektronische Vorrichtung (1) nach einem der vorstehenden Ansprüche, wobei die Poren (1221) des porösen Aluminiumoxids (122) Kanäle (122a) bilden, die in der erste Fläche (12a) der Einschlussschicht (12) münden.

5. Optoelektronische Vorrichtung (1) nach einem der vorstehenden Ansprüche, wobei mindestens bestimmte der Poren (1221) eine Längenabmessung Lp aufweisen, im Vorsprung entlang einer Richtung senkrecht zu der ersten Fläche (12a) genommen, die mindestens gleich und bevorzugt strikt, beispielsweise um 2 nm, kleiner als eine Dicke der Lichteinschlussschicht (12) ist.

6. Optoelektronische Vorrichtung (1) nach einem der vorstehenden Ansprüche, wobei sich die Poren (1221) im Wesentlichen bis zu der Stapelung (11) erstrecken.

7. Optoelektronische Vorrichtung (1) nach einem der Ansprüche 1 und 3-6, wobei mindestens eine Pore (1221) einen Formfaktor aufweist, der von den Querabmessungen, die im Wesentlichen zwischen 40 nm und 800 nm liegen, und/oder einer Längsabmessung, die im Wesentlichen zwischen 500 nm und 10 nm, bevorzugt im Wesentlichen zwischen 1 µm und 5 µm liegt, definiert ist.

8. Optoelektronische Vorrichtung (1) nach einem der vorstehenden Ansprüche, wobei die offenen Poren (1221) auf der ersten Fläche der Einschlussschicht (12) eine Oberfläche im Wesentlichen gleich 30 % der Gesamtoberfläche dieser Einschlussschicht belegen und/oder die offenen Poren (1221) oberhalb mindestens einer Leuchtdiode (111), die paarweise durch ihre Mittenpunkte aneinandergrenzen, um einen Abstand im Wesentlichen gleich einer Wellenlänge des Lichts, das von der darunterliegenden Leuchtdiode (111) emittiert wird, beabstandet sind, wobei diese Wellenlänge in der Regel dem Spektrum von blauem Licht angehört, also beispielsweise zwischen 380 und 450 nm.

9. Optoelektronische Vorrichtung (1) nach einem der vorstehenden Ansprüche, wobei die Stapelung (11) außerdem Folgendes umfasst:
• ein Trägersubstrat (113) und
• eine Matrix aus emittierenden Strukturen (1112), die sich auf dem Trägersubstrat (113) erstreckt,
wobei die Matrix aus emittierenden Strukturen (1112) die Vielzahl von Leuchtdioden (111) umfasst, die sich auf dem Trägersubstrat (113) über eine Grenzschicht (114) erstreckt, und die Vielzahl elektrisch leitfähiger Kontaktstücke, die sich optional auf dem Trägersubstrat (113) über eine elektrische Isolationswand (117) erstreckt.

10. Optoelektronische Vorrichtung (1) nach einem der vorstehenden Ansprüche, die außerdem ein Lichtfarbenumwandlungsmaterial (123) umfasst, das sich in den Poren (1221) des porösen Aluminiumoxids (122) befindet, das sich in Ausrichtung mit mindestens einer Leuchtdiode (111) befindet, bevorzugt in Ausrichtung mit jeder Leuchtdiode.

11. Optoelektronische Vorrichtung (1) nach dem vorstehenden Anspruch, wobei sich mindestens eine, bevorzugt jede Pore (1221) auf der ersten Fläche (12a) der Einschlussschicht (12) öffnet, die der Stapelung (11) entgegengesetzt ist, eine Füllrate mit dem Lichtfarbenumwandlungsmaterial im Wesentlichen gleich 30 % aufweist.

12. Optoelektronische Vorrichtung (1) nach Anspruch 10, wobei die Lichteinschlussschicht (12) in mindestens einem, potenziell in mehreren der Räume (10) frei von porösem Aluminiumoxid (122) ist.

13. Verfahren zur Herstellung einer optoelektronischen Vorrichtung (1), das die folgenden Schritte umfasst:
• Bereitstellen einer Stapelung (11), die Folgendes umfasst:
i. eine Vielzahl von Leuchtdioden (111) mit P-N-Übergang, die voneinander beabstandet angeordnet sind, um
ii. eine Vielzahl elektrisch leitfähiger Kontaktstücke (112), die zwischen den Leuchtdioden angeordnet sind,
wobei die elektrisch leitfähigem Kontaktstücke elektrisch von mindestens einer p- oder n-Zone der P-N-Übergänge der Leuchtdioden isoliert sind,
• Bilden auf der Stapelung (11) einer Lichteinschlussschicht (12), die reflektierende Wände (121) umfasst, die zwischen einander Räume (10) definieren, die jeweils in Ausrichtung mit einer Leuchtdiode (111) liegen, durch
i. Abscheiden einer Schicht (1000, 2000) auf Aluminiumbasis auf einer Hauptfläche (11a) der Stapelung (11), durch die die Leuchtdioden (111) emittieren sollen, dann
ii. Eloxieren der Schicht (1000, 2000) auf Aluminiumbasis mindestens außerhalb von Zonen, die zu den leitfähigen Kontaktstücken (112) der Stapelung (11) ausgerichtet liegen,
• wobei das Eloxieren derart parametriert ist, dass das poröse Aluminiumoxid (122) in mindestens bestimmten der Räume (10) gebildet wird, indem es in mindestens einem Raum, bevorzugt in mindestens zwei Räumen, ja sogar jedem Raum der mindestens bestimmten der Räume (10) mindestens zwei Poren (1221) aufweist, die auf einer ersten Fläche (12a) der Einschlussschicht (12), die sich der Stapelung (11) entgegengesetzt befindet, offen sind,
Verfahren **dadurch gekennzeichnet, dass** der Eloxierschritt das Eloxieren eines Teils der Schicht (1000, 2000) auf Aluminiumbasis umfasst, der zu mindestens einem elektrisch leitfähigen Kontaktstück (112) ausgerichtet ist, und außerdem das Abscheiden eines reflektierenden Materials (1212) in den Poren des porösen Aluminiumoxids (1211) umfasst, die sich zu dem mindestens einen elektrisch leitfähigen Kontaktstück (112) erstrecken.

14. Herstellungsverfahren nach dem vorstehenden Anspruch, wobei der Eloxierschritt der Schicht (1000, 2000) auf Aluminiumbasis derart parametriert ist, dass das poröse Aluminiumoxid (122) Kanäle (122a) bildet, die in den Poren (1221) münden, die sich auf der ersten Fläche (12a) der Einschlussschicht (12) öffnen, und bevorzugt derart, dass mindestens ein Kanal (122a), beispielsweise jeder Kanal, Querabmessungen aufweist, die im Wesentlichen zwischen 40 nm und 800 nm liegen, und/oder eine Längsabmessung im Wesentlichen zwischen 500 nm und 10 µm, bevorzugt im Wesentlichen zwischen 1 µm und 6 µm.

15. Anzeigebildschirm oder Projektionssystem für mindestens ein Bild, der (das) mindestens eine optoelektronische Vorrichtung (1) nach einem der Ansprüche 1 bis 12 umfasst.

## Claims

1. Optoelectronic device (1) comprising:
• a stack (11) comprising:
i. a plurality of P-N junction light-emitting diodes (111) disposed at a distance from one another, and
ii. a plurality of electrically conductive terminals (112) disposed between the light-emitting diodes (111),
the electrically conductive terminals (112) being electrically isolated from at least one p or n zone of the P-N junctions of the light-emitting diodes, and
• a light confinement layer (12) extending over a stack (11) and comprising reflective walls (121) defining between them, spaces (10) each located to the right of at least one, preferably of each, light-emitting diode (111),
the optoelectronic device (1) being such that the light confinement layer (12) further comprises the porous alumina (122) in at least some of said spaces (10), the porous alumina (122) having, in at least one space, preferably at least two spaces, even in each space, from among said at least some of said spaces, at least two open pores (1221) on a first face (12a) of the confinement layer (12) which is located opposite the stack (11), the optoelectronic device (1) being characterised at least in that the at least one, potentially each, reflective wall (121) is porous alumina (1211)-based and with the basis of a reflective material (1212) located in the pores of the porous alumina (1211).

2. Optoelectronic device (1) according to the preceding claim, wherein the pores (1221) of the porous alumina (122) have transverse dimensions of between 1 and 500nm, and preferably between 50 and 400nm, and wherein the pores (1221) of the porous alumina (122) have a periodicity of between 200 and 700nm.

3. Optoelectronic device (1) according to any one of the preceding claims, wherein the porous alumina (122) has, in at least one space, preferably at least two spaces, even in each space, from among said at least some of said spaces, at least eight open pores (1221) on the first face (12a) of the confinement layer (12) which is located opposite the stack.

4. Optoelectronic device (1) according to any one of the preceding claims, wherein the pores (1221) of the porous alumina (122) form channels (122a) opening onto the first face (12a) of the confinement layer (12).

5. Optoelectronic device (1) according to any one of the preceding claims, wherein the pores (1221) have a dimension Lp by length, taken in projection along a direction perpendicular to the first face (12a), at most equal, and preferably strictly less, for example by 2nm, than a thickness of the light confinement layer (12).

6. Optoelectronic device (1) according to any one of the preceding claims, wherein the pores (1221) extend substantially up to the stack (11).

7. Optoelectronic device (1) according to any one of the preceding claims, wherein at least one pore (1221) has a form factor defined by transverse dimensions substantially of between 40nm and 800nm, and/or a longitudinal dimension substantially of between 500nm and 10µm, preferably substantially of between 1µm and 5µm.

8. Optoelectronic device (1) according to any one of the preceding claims, wherein the open pores (1221) on the first face of the confinement layer (12) occupy a surface substantially equal to 30% of the total surface of this confinement layer and/or the open pores (1221) above at least one light-emitting diode (111) which are adjacent to one another can be distant in pairs, by their centres, by a distance substantially equal to a wavelength of the light emitted by the underlying light-emitting diode (111), this wavelength typically belonging to the blue light spectrum, that is, for example, between 380 and 450nm.

9. Optoelectronic device (1) according to any one of the preceding claims, wherein the stack (1) further comprises:
• a carrier substrate (113), and
• an emissive structure matrix (1112) extending over the carrier substrate (113),
the emissive structure matrix (1112) comprising the plurality of light-emitting diodes (111) which extend over the carrier substrate (113) through an interfacing layer (114) and the plurality of electrically conductive terminals which extends optionally over the carrier substrate (113) through an electrical isolation wall (117).

10. Optoelectronic device (1) according to any one of the preceding claims, further comprising a light colour conversion material (123) located in the pores (1221) of the porous alumina (122) located to the right of at least one light-emitting diode (111), preferably to the right of each light-emitting diode.

11. Optoelectronic device (1) according to the preceding claim, wherein at least one, preferably each, pore (1221) open on the first face (12a) of the confinement layer (12) which is located opposite the stack (11) has a filling rate, made of the light colour conversion material, substantially equal to 30%.

12. Optoelectronic device (1) according to claim 10, wherein the light confinement layer (12) has no porous alumina (122) in at least one, potentially in more, of said spaces (10).

13. Method for manufacturing an optoelectronic device (1) comprising the following steps:
• providing a stack (11) comprising:
i. a plurality of P-N junction light-emitting diodes (111) disposed at a distance from one another, and
ii. a plurality of electrically conductive terminals (112) disposed between the light-emitting diodes,
the electrically conductive terminals being electrically isolated from at least one p or n zone of the P-N junctions of the light-emitting diodes,
• forming, on the stack (11), a light confinement layer (12) comprising reflective walls (121) defining between them, spaces (10), each located to the right of a light-emitting diode (111), by
i. deposition of an aluminium-based layer (1000, 2000) on a main face (11a) of the stack (11) through which the light-emitting diodes (111) are configured to emit, then
ii. anodising the aluminium-based layer (1000, 2000) at least outside of zones located to the right of the conductive terminals (112) of the stack (11),
• the anodising being configured such that the porous alumina (122) is formed in at least some of said spaces (10), by having, in at least one space, preferably at least two spaces, even in each space, from among said at least some of said spaces (10), at least two open pores (1221) on a first face (12a) of the confinement layer (12) which is located opposite the stack (11),
the method being **characterised in that** the anodising step comprises the anodising of some of the aluminium-based layer (1000, 2000) which is located to the right of at least one electrically conductive terminal (112) and further comprising the deposition of a reflective material (1212) in the pores of the porous alumina (1211) located to the right of said at least one electrically conductive terminal (112).

14. Manufacturing method according to the preceding claim, wherein the step of anodising the aluminium-based layer (1000, 2000) is configured such that the porous alumina (122) form channels (122a) opening through the open pores (1221) on the first face (12a) of the confinement layer (12), and preferably such that at least one channel (122a), for example each channel, has transverse dimensions substantially of between 40nm and 800nm, and/or a longitudinal dimension substantially of between 500nm and 10µm, preferably substantially of between 1µm and 6µm.

15. Display screen or system for projecting at least one image comprising at least one optoelectronic device (1) according to any one of claims 1 to 12.
